(19) Europäisches Patentamt
European Patent Office
Office européen des brevets

(11) **EP 1 186 897 B1**

(12) **EUROPEAN PATENT SPECIFICATION**

(45) Date of publication and mention
of the grant of the patent:
**25.04.2007 Bulletin 2007/17**

(51) Int Cl.:
*G01R 31/28* (2006.01)  *F02M 65/00* (2006.01)

(21) Application number: **00119691.4**

(22) Date of filing: **08.09.2000**

(54) **Method and apparatus for the simulation of the electrical behavior of piezoelectric elements**

Verfahren und Vorrichtung zum Simulieren des elektrischen Verhaltens eines piezoelektrischen Elements

Procédé et dispositif de simulation du comportement électrique d'éléments piezoélectriques

(84) Designated Contracting States:
**AT BE CH CY DE DK ES FI FR GB GR IE IT LI LU MC NL PT SE**

(43) Date of publication of application:
**13.03.2002 Bulletin 2002/11**

(73) Proprietor: **ROBERT BOSCH GMBH**
**70469 Stuttgart (DE)**

(72) Inventor: **Hedenetz, Andreas**
**73770 Denkendorf (DE)**

(56) References cited:
• **KASUGA C ET AL: "Characteristics analysis method of multi-layer piezo-ceramic actuator simulation of equivalent circuit using the state space method" PROCEEDINGS OF THE 1992 INTERNATIONAL CONFERENCE ON INDUSTRIAL ELECTRONICS, CONTROL, INSTRUMENTATION, AND AUTOMATION. POWER ELECTRONICS AND MOTION CONTROL (CAT. NO.92CH3137-7), SAN DIEGO, CA, USA, 9-13 NOV. 1992, pages 336-339 vol.1, XP002158102 1992, New York, NY, USA, IEEE, USA ISBN: 0-7803-0582-5**
• **KASUGA C ET AL: "Characteristics analysis of multi-layer piezo-ceramic actuator. II" PROCEEDINGS OF THE IECON '93. INTERNATIONAL CONFERENCE ON INDUSTRIAL ELECTRONICS, CONTROL, AND INSTRUMENTATION (CAT. NO.93CH3234-2), PROCEEDINGS OF IECON '93 - 19TH ANNUAL CONFERENCE OF IEEE INDUSTRIAL ELECTRONICS, MAUI, HI, USA, 15-19 NOV. 1993, pages 1573-1576 vol.3, XP002158103 1993, New York, NY, USA, IEEE, USA ISBN: 0-7803-0891-3**

**Description**

The present invention concerns a method as defined in the preamble of Claim 1 and an apparatus as defined in the preamble of Claim 8, i.e. a method and an apparatus for the simulation of the electrical behavior of piezoelectric elements.

Piezoelectric elements are used for example as actuators for highly precise mechanical movements. This is possible, since piezoelectric elements change their extent in dependence on a voltage applied across the element. By way of example, piezoelectric elements are used as actuators in fuel injection nozzles of an internal combustion engine. In this example, fuel injection is controlled by means of applying voltages to piezoelectric actuators which expand or contract themselves as a function of the voltage applied. Resulting thereof, an injector needle which is connected to the piezoelectric actuators by means of a transfer system is moved up and down and therefore an injection nozzle is opened or closed.

The simulation of the electrical behavior of piezoelectric elements is of particular interest for testing purposes such as laboratory tests of activation ICs for the control of piezoelectric elements.

The electrical behavior of piezoelectric has a certain similarity to the electrical behavior of capacitors.

The document "characteristics analysis method of multi-layer piezo-ceramic actuator simulation of equivalent circuit using the state space method" of KASUGA C ET AL; proceedings of the 1992 INTERNATIONAL CONFERENCE OF INDUSTRIAL ELECTRONICS, CONTROL, INSTRUMENTATION, AND AUTOMATION, POWER ELECTRONICS AND MOTION CONTROL, XP002158102, comprises an analysis of a piezoelectric element employing the state space method. In order to examine the characteristics of a multi-layer piezo-ceramic actuator an equivalent circuit is employed which accounts for dielectric losses within the piezo-ceramic actuator.

The document "characteristics analysis method of multi-layer piezo-ceramic actuator simulation of equivalent circuit using the state space method (Part II)" of KASUGA C ET AL; proceedings of the IECON 1993 INTERNATIONAL CONFERENCE ON INDUSTRIAL ELECTRONICS, CONTROL AND INSTRUMENTATION XP002158103, discloses a drive circuit for a piezo-ceramic actuator. The described drive circuit comprises an additional capacitive element in parallel to a high voltage electric source.

It is the object of the present invention, to provide an improved method and apparatus for the simulation of the electrical behavior of piezoelectric elements.

The object of the present invention is achieved by the object of method claim 1. Discharging the first capacitor covers complete discharging, i. e., discharging the first capacitor to OV across the first capacitor as well as non complete discharging, i. e., discharging the first capacitor to a certain voltage across the first capacitor.

The object of the present invention is further achieved by the object of apparatus claim 8.

The present invention allows a rather precise simulation of the electrical behavior of piezoelectric elements, particularly concerning the electrical efficiency and the charging and discharging currents. In more detail, according to the present invention it is possible to have a relatively large charging current but a discharging current which is for example reduced by 40-50 % compared to the charging current. It turned out that it is possible, to simulate the electrical loss which would occur while using a piezoelectric element. This is of particular interest for the testing of control devices in laboratory tests, in which for example the eligibility of a control device for a far range of different piezoelectric elements is to be tested or for which the use of real piezoelectric elements would be to expensive.

It is to be understood, that by means of any larger number of inventive devices or performs of the inventive method any larger number of piezoelectric elements may be simulated. Hence, it is possible to simulate for example six piezoelectric elements as used for actuation of six valves in a six cylinder engine of a car by means of using six inventive devices (etc.).

In a preferred embodiment of the invention a first capacitor having a first capacitance and a second capacitor having a second capacitance are charged through the first circuit or the first part of the circuit during the charging procedure and only the first capacitor is discharged through the first circuit or the first part of the circuit during the discharging procedure.

In a further preferred embodiment of the invention the second capacitor is discharged through a second circuit or a second part of the circuit.

In a further preferred embodiment of the invention the second capacitor is discharged by controlling the voltage across the second capacitor depending on a voltage across the first capacitor.

In a further preferred embodiment of the invention the voltages across the first and the second capacitor are adjusted to each other before a charging procedure.

In a further preferred embodiment of the invention the voltages across the first and the second capacitor are adjusted to each other before a charging procedure by means of a comparator, which compares the voltages across each capacitor to each other and which closes the switch within the second circuit or the second part of the circuit as long as the voltage across the second capacitor is above the voltage across the first capacitor.

In a further preferred embodiment of the invention voltage dividers are used to reduce the voltages applied across the capacitors for comparison purposes.

In a further preferred embodiment of the invention the first capacitor has a first capacitance and the second capacitor has a second capacitance, wherein the first capacitance and the second capacitance at least approximately fulfill the equation

$$\eta = \frac{C1}{C1+C2}$$

wherein $\eta$ is the electrical efficiency of the simulated piezo-electric element and C1 and C2 are the capacitances of the first resp. the second capacitor.

In a further preferred embodiment of the invention the apparatus comprises a second circuit or a second part of a circuit for discharging the second capacitor.

In a further preferred embodiment of the invention the second circuit or the second part of the circuit comprises a discharge controller for controlling a voltage across the second capacitor.

In a further preferred embodiment of the invention the discharge controller controls the voltage across the second capacitor depending on a voltage across the first capacitor.

In a further preferred embodiment of the invention the discharge controller controls the voltage across the second capacitor such that the voltage across the second capacitor follows the voltage across the first capacitor.

In a further preferred embodiment of the invention the discharge controller comprises a switch for controlling the discharging of the second capacitor.

In a further preferred embodiment of the invention the discharge controller comprises a resistor for adjusting the discharging time of the second capacitor.

In a further preferred embodiment of the invention the discharge controller comprises a comperator for comparing the voltages across the first capacitor and the second capacitor and for closing the switch as long as the voltage across the second capacitor is above the voltage across the first capacitor.

The present invention will be explained in further detail below with reference to exemplary embodiments, referring to the figures in which:

FIG.1  shows a circuit diagram of an exemplary embodiment of an inventive apparatus which is eligible for use with the inventive method;

FIG.2  shows a charging procedure performed with the exemplary embodiment of FIG.1 as according to the inventive method;

FIG.3  shows a discharging procedure performed with the exemplary embodiment of FIG.1 as according to the inventive method; and

FIG.4  shows a voltage diagram illustrating the control of the voltage across a second capacitor as according to the present invention.

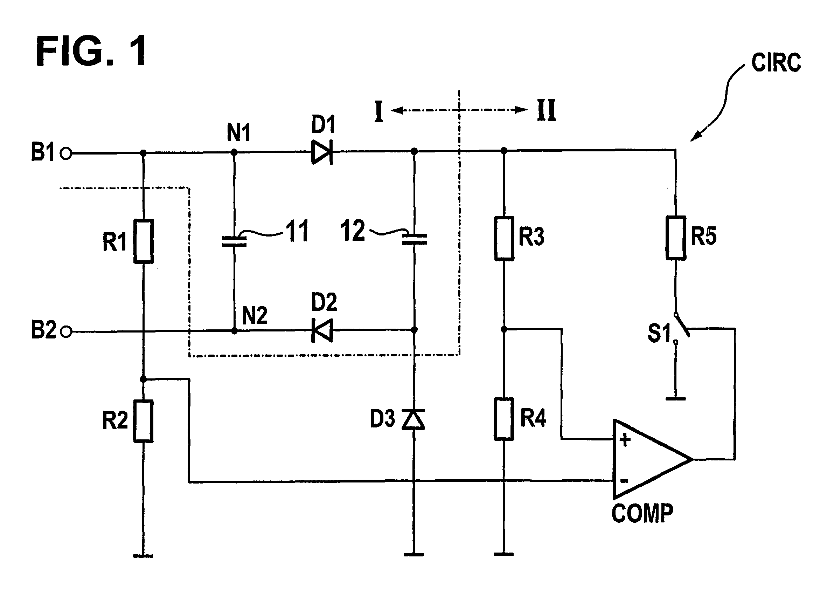

The exemplary embodiment of an inventive apparatus within FIG.1 comprises a first and a second capacitor having a first and a second capacitance C1 resp. C2. However, it is to be understood, that any larger number of capacitors would also match the object of the present invention while modifying the below described relations in a corresponding way.

The first and the second capacitor 11 and 12 are connected to each other in parallel. The capacitors 11 and 12 are implemented in a circuit CIRC which allows to commonly charge but separately discharge the first and the second capacitor 11 and 12 and which will be explained in further detail below. Hence an energy loss can be simulated as will be likewise explained in further detail below. The capacitances C1 and C2 are selected in accordance with the equation

$$\eta_{piezo} = \frac{C1}{C1+C2}$$

wherein $\eta_{piezo}$ is the electrical efficiency corresponding to the simulated piezoelectric element. This is because of the following relations:

- the electrical efficiency $\eta_{piezo}$ of the piezoelectric element is defined as

$$\eta_{piezo} = \frac{W_{out}}{W_{in}}$$

wherein $W_{in}$ is the energy which was brought onto the piezoelectric element during a charging procedure and $W_{out}$ is the energy which comes out of the piezoelectric element during the following discharging procedure;

- the resulting electrical efficiency $\eta_{res}$ of the exemplary simulation apparatus is supposed to be as close as possible to the electrical efficiency $\eta_{piezo}$ of the piezoelectric element

$$\eta_{res} \cong \eta_{piezo}$$

- recalling, that the first and the second capacitor 11 and 12 can be commonly charged but separately discharged (as will be explained in further detail below), the resulting electrical efficiency $\eta_{res}$ of the exemplary simulation apparatus can be described as

$$\eta_{res} = \frac{W_1}{W_{1,2}}$$

wherein $W_1$ is the energy stored in the first capacitor having the first capacitance C1 and $W_{1,2}$ is the total energy stored in the first and the second capacitor having the first resp. the second capacitances C1 resp. C2

- the energies $W_1$ and $W_{1,2}$ can be determined from the capacitances C1 and C2 of the capacitors as

$$W_1 = \frac{C1 * U^2}{2}$$

and

$$W_{1,2} = \frac{(C1 + C2) * U^2}{2}$$

wherein $U^2$ is the square of the voltage across each capacitor (which is about the same voltage for both capacitors since they are connected to each other in parallel) and hence

- the resulting electrical efficiency $\eta_{res}$ of the exemplary simulation apparatus can be described as

$$\eta_{res} = \frac{W_1}{W_{1,2}} \approx \frac{C1}{C1 + C2} = \eta_{piezo}$$

As a result, it is possible to simulate any desired electrical efficiency $\eta_{piezo}$ corresponding to the properties of any piezoelectric element by means of an eligible selection of capacitors having capacitances C1 and C2 matching the above equation, as will be explained in further detail below.

In more detail, the first and the second capacitor 11 and 12 are commonly charged through a first part I of the circuit CIRC in which the capacitors 11 and 12 are implemented. However, only the first capacitor 11 is discharged through the first part I of the circuit CIRC, whereas the second capacitor 12 is discharged through a second part II of the circuit CIRC.

The first part I of the circuit CIRC comprises a first and a second terminal B1 resp. B2, the first and the second capacitor 11 resp. 12 and a first and a second diode D1 resp. D2. The second part II of the circuit CIRC comprises a first voltage divider implemented as a first and a second resistor R1 resp. R2, a second voltage divider implemented as a third and a fourth resistor R3 resp. R4, a fifth resistor R5 and a comparator COMP.

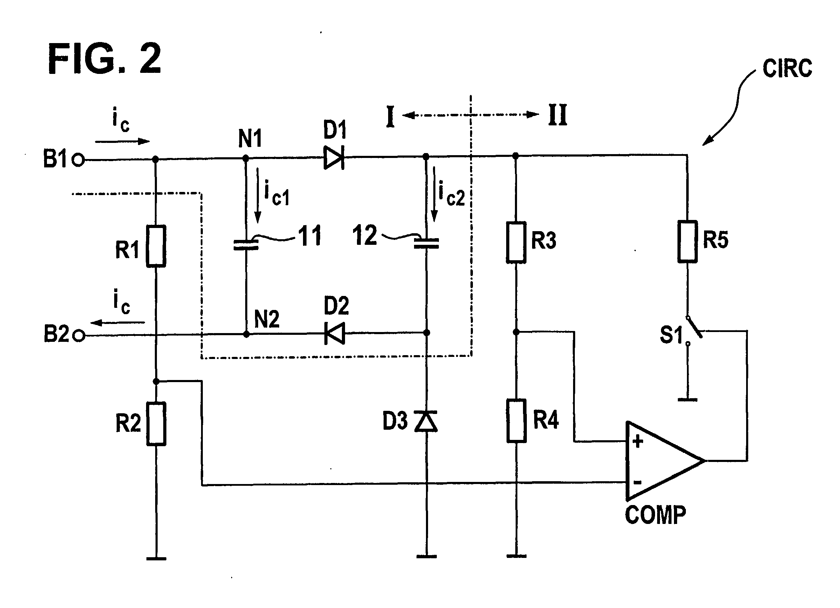

The charging of the capacitors 11 and 12 is explained while referring to FIG.2. A charging current $i_c$ enters the first part I of the circuit CIRC through the first terminal B1. Hence, the general direction of the charging current $i_c$ leads from the first terminal B1 to the second terminal B2.

At a first node N1 the charging current $i_c$ is split up into a first and a second charging current $i_{c1}$ resp. $i_{c2}$. For this, the following relation holds:

$$i_c = i_{c1} + i_{c2}$$

The first charging current $i_{c1}$ goes immediately to the one side of the first capacitor 11. The second charging current $i_{c2}$ goes to the one side of the second capacitor 12 through the first diode D1 which is poled in its conducting direction.

On the other side of the first capacitor 11, the first charging current $i_{c1}$ goes immediately to a second node N2. The second charging current $i_{c2}$ goes on the other side of the second capacitor 12 to the second node N2 through the second diode D2 which is likewise poled in its conducting direction.

At the second node N2 the first and the second charging current $i_{c1}$ resp. $i_{c2}$ are combined again with each other. The resulting total charging current $i_c$ is then lead to the second terminal B2. Resulting thereof, both the first and the second capacitor can be charged to about the same voltage.

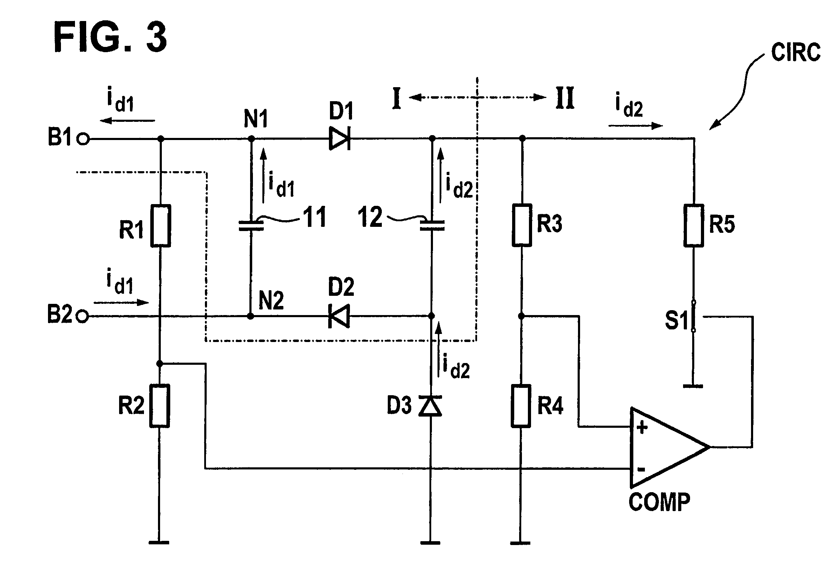

The discharging of the capacitors 11 and 12 is explained while referring to FIG.3:

The general direction of a first discharging current $i_{d1}$ within the first part I of the circuit CIRC leads from the second terminal B2 to the first terminal B1 and hence in the opposite direction than the charging current $i_c$ does. Hence, the first and the second diode D1 and D2 are not any longer poled in their conducting directions but are now poled in their blocking directions. Resulting thereof, the first discharging current $i_{d1}$ within the first part I of the circuit CIRC goes from the second terminal B2 through the first capacitor 11 to the first terminal B1 without any effect on resp. without any effect due to the second capacitor 12.

On the other hand, the second capacitor 12 is discharged by means of closing a switch S1 (the switch S1 itself may be implemented as a MOS-FET or as any other eligible device). As soon as the switch S1 is closed, a second discharging current $i_{d2}$ occurs, which goes from ground through a third diode D3 (which is poled in its conducting direction) through the second capacitor 12 and through a fifth resistor R5 to the ground (the purpose of the fifth resistor R5 is the limitation of the size of the discharging current $i_{d2}$ as well as the regulation of the discharging time).

As a result, during a charging procedure the total charging current $i_c$ occurs between the first and the second terminal B1 resp. B2. On the other hand, during a discharging procedure only the first discharging current $i_{d1}$ occurs between the second and the first terminal B2 resp. B1. Hence, within a corresponding control device which is connected to the two terminals B1 and B2 (not shown) during a charging procedure the total charging current $i_c$ but during a discharging procedure the first discharging current $i_{d1}$ only would occur. While doing so, the described arrangement of diodes ensures that (basically) no further currents occur within the control device due to the second part II of the circuit CIRC.

In order to fulfill the above described equation

$$\eta_{piezo} = \frac{C1}{C1 + C2}$$

it is furthermore advantageous, that both capacitors 11 and 12 are at least approximately at the same voltage before a charging procedure takes place.

Principally, this aim can be achieved by means of completely discharging both capacitors 11 and 12 just by means of applying a sufficiently long discharging time. However, the described embodiment of the inventive apparatus resp. method allows to equalize the voltages of the two capacitors 11 and 12 no matter whether the resulting voltage is zero or any other desired voltage.

For this purpose, the two voltage dividers (comprising the first through fourth resistor R1, R2, R3 and R4) and the comparator COMP are implemented in the second part II of the circuit CIRC.

In more detail, the first and the second voltage divider R1 and R2, resp. R3 and R4 divide the occurring voltages to a level, which can be compared by means of the comparator COMP (the resistors R1, R2, R3 and R4 are sufficiently high-resistive, that effects on the charging or discharging currents due to currents occurring through the resistors R1, R2, R3 and R4 are neglec-table). In case the voltage across the second capacitor 12 is above the voltage across the first capacitor 11, the comparator COMP returns a control signal, which causes the switch S1 to close and vice versa. Resulting thereof, the voltage across the second capacitor 12 is automatically reduced whenever it exceeds the voltage across the first capacitor 11. Hence, there is no need for a special control of the voltage across the second capacitor by means of the control device (not shown). Furthermore, by means of an eligible selection of the fifth resistor R5 the discharging time of the second capacitor 12 can be adjusted.

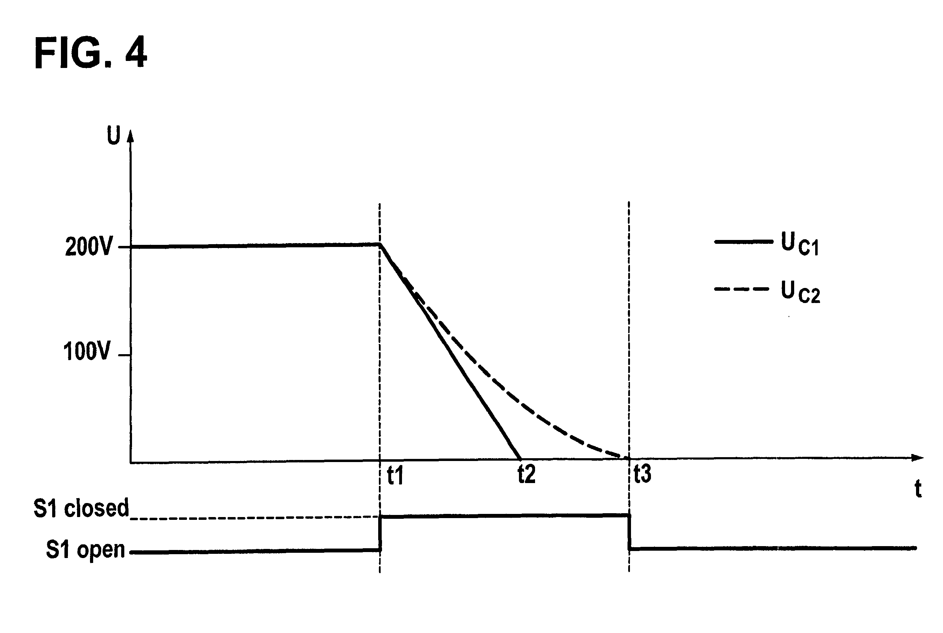

The control of the discharging procedure for the second capacitor 12 by means of the comparator COMP and the switch S1 is further described while referring to FIG.4. Within FIG.4, a first voltage $U_{c1}$ across the first capacitor 11 is indicated by a solid line and a second voltage $U_{c2}$ across the second capacitor 12 is indicated by a dashed line. The voltages are depicted as functions over the time.

Within the example shown, until a first time both voltages $U_{c1}$ and $U_{c2}$ are equal to each other and remain constantly 200 V. Then, between the first time t1 and a second time t2 the first voltage $U_{c1}$ is reduced to 0 V. Because of this, at the first time t1 the switch S1 is closed by the comparator COMP as indicated by a graph below the time axis t. According hereto, the second voltage $U_{c2}$ is reduced to zero until a third time t3 which is after the second time t2. Then, at the third time t3 the switch S1 is opened again as indicated by the graph below the time axis t.

As shown in FIG. 4, the resistors R1, R2, R3, R4, and R5, the comperator COMP, and the switch S1 implement a discharge controller for controlling the voltage across the second capacitor 12 based on the value of the voltage across the first capacitor, when the second capacitor 12 is discharged. Other implementation of such a discharge controller may be used as well.

It is to be understood, that other embodiments of the inventive apparatus resp. of the inventive method beyond those described herein are intended to be within the scope of the present invention. For example, a larger number of capacitors can be used. The present invention is intended to be limited only by the scope of the attached claims.

## Claims

1.  Method for the simulation of the electrical behaviour of piezoelectric elements, wherein

    a) at least a first capacitor (11) and a second capacitor (12) are simultaneously charged through a first part (I) of a circuit (CIRC) during a charging procedure, **characterized in that**
    b) at least said first capacitor (11) of said at least first and second capacitors (11, 12) is discharged through said first part (I) of the circuit (CIRC) during a discharging procedure, and **in that** at least said second capacitor (12) of said capacitors (11, 12) is not discharged through said first part (I) of the circuit (CIRC) during said discharging procedure.

2.  Method as recited in claim 1, **characterized in that** only the first capacitor (11) is discharged through said first part (I) of the circuit (CIRC) during said discharging procedure.

3.  Method as recited in one of the foregoing claims, **characterized in that** the second capacitor (12) is discharged through a second part (II) of the circuit (CIRC).

4.  Method as recited in claim 3, **characterized in that** the second capacitor (12) is discharged by controlling the voltage ($U_{c2}$) across the second capacitor (12) depending on a voltage ($U_{c1}$) across the first capacitor (11).

**5.** Method as recited in one of the foregoing claims, **characterized in that** the first and the second capacitor (11, 12) are at least approximately at the same voltage before starting said charging procedure.

**6.** Method according to claim 5, **characterized in that** said step of charging said first and said second capacitor (11, 12) to at least approximately the same voltage is performed by means of a comparator (COMP)

a) which compares the voltages (Uc1, Uc2) across each capacitor (11, 12) to each other; and
b) which closes a switch (S1), that is comprised within the/a second part (II) of the circuit (CIRC) and that discharges said second capacitor (12), as long as the voltage ($U_{c2}$) across the second capacitor (12) is above the voltage ($U_{c1}$) across the first capacitor (11).

**7.** Method as recited in one of the foregoing claims, **characterized in that** voltage dividers (R1 and R2; R3 and R4) are used, for comparison purposes, to reduce the voltages (Uc1, Uc2) the capacitors (11, 12) are charged to.

**8.** Apparatus for simulation of the electrical behaviour of a piezoelectric element, in particular eligible for use with the method as recited in one of the foregoing claims, wherein the apparatus comprises at least a first capacitor (11) and a second capacitor (12) which are implemented in a first part (I) of a circuit (CIRC) of said apparatus, the apparatus being configured to simultaneously charge the first capacitor (11) and the second capacitor (12) through the first part (I) of the circuit (CIRC), **characterized in that** said apparatus is configured to discharge only the first capacitor (11) through said first part (I) of said circuit (CIRC).

**9.** Apparatus as recited in claim 8, **characterized in that** the first capacitor (11) has a first capacitance (C1) and the second capacitor (12) has a second capacitance (C2), wherein the first capacitance (C1) and the second capacitance (C2) at least approximately fulfil the equation η = C1 / (C1 + C2), wherein η is the electrical efficiency of the simulated piezoelectric element and C1 and C2 are the capacitances of the first resp. the second capacitor (11, 12).

**10.** Apparatus as recited in claim 8 or 9, **characterized in that** it comprises a second part (II) of a circuit (CIRC) for discharging the second capacitor (12).

**11.** Apparatus as recited in claim 10, **characterized in that** the second part (II) of the circuit (CIRC) comprises a discharge controller for controlling a voltage ($U_{c2}$) across the second capacitor (12).

**12.** Apparatus as recited in claim 11, **characterized in that** the discharge controller controls the voltage across ($U_{c2}$) the second capacitor (12) depending on a voltage ($U_{c1}$) across the first capacitor (11).

**13.** Apparatus as recited in claim 12, **characterized in that** the discharge controller controls the voltage ($U_{c2}$) across the second capacitor (12) such that the voltage ($U_{c2}$) across the second capacitor (12) follows the voltage ($U_{c1}$) across the first capacitor (11).

**14.** Apparatus as recited in claim 11, 12, or 13 **characterized in that** the discharge controller comprises a switch (S1) for controlling of the discharging of the second capacitor (12).

**15.** Apparatus as recited in claim 11, 12, 13 or 14, **characterized in that** the discharge controller comprises a resistor (R5) for adjusting the discharging time of the second capacitor (12).

**16.** Apparatus as recited in claim 14 or 15 **characterized in that** the discharge controller comprises a comparator (COMP) for comparing the voltages (Uc1, Uc2) across the first capacitor (11) and the second capacitor (12) and for closing the switch (S1) as long as the voltage ($U_{c2}$) across the second capacitor (12) is above the voltage (Uc1) across the first capacitor (11).

**17.** Apparatus according to one of the claims 8 to 16, **characterized in that** said first part (I) of said circuit (CIRC) comprises a first diode (D1), an anode of which is connected to a first terminal (N1) of said first capacitor (11) and a cathode of which is connected to a first terminal of said second capacitor (12), **in that** said first part (I) of said circuit (CIRC) comprises a second diode (D2), an anode of which is connected to the second terminal of said second capacitor (12) and a cathode of which is connected to the second terminal (N2) of said first capacitor (11), and **characterized by** a third diode (D3), an anode of which is connected to ground potential and a cathode of which is connected to said second terminal of said second capacitor (12).

**18.** Apparatus according to claim 17, **characterized in that** a/said switch (S1) for controlling of the discharging of said second capacitor (12) connects said first terminal of said second capacitor (12) to ground potential, preferably via a resistor (R5).

**Patentansprüche**

1.  Verfahren für die Simulation des elektrischen Verhaltens von piezoelektrischen Elementen, wobei

    a) mindestens ein erster Kondensator (11) und ein zweiter Kondensator (12) gleichzeitig durch einen ersten Teil (I) einer Schaltung (CIRC) während einer Ladeprozedur geladen werden, **dadurch gekennzeichnet, daß**
    b) mindestens der erste Kondensator (11) des mindestens ersten und zweiten Kondensators (11, 12) durch den ersten Teil (I) der Schaltung (CIRC) während einer Endladeprozedur entladen wird und daß mindestens der zweite Kondensator (12) der Kondensatoren (11, 12) nicht durch den ersten Teil (I) der Schaltung (CIRC) während der Entladeprozedur entladen wird.

2.  Verfahren nach Anspruch 1, **dadurch gekennzeichnet, daß**
    nur der erste Kondensator (11) durch den ersten Teil (I) der Schaltung (CIRC) während der Entladeprozedur entladen wird.

3.  Verfahren nach einem der vorhergehenden Ansprüche, **dadurch gekennzeichnet, daß** der zweite Kondensator (12) durch einen zweiten Teil (II) der Schaltung (CIRC) entladen wird.

4.  Verfahren nach Anspruch 3, **dadurch gekennzeichnet, daß** der zweite Kondensator (12) durch Steuern der Spannung (Uc2) an dem zweiten Kondensator (12) je nach einer Spannung (Uc1) an dem ersten Kondensator (11) entladen wird.

5.  Verfahren nach einem der vorhergehenden Ansprüche, **dadurch gekennzeichnet, daß** der erste und der zweite Kondensator (11, 12) zumindest ungefähr die gleiche Spannung aufweisen, bevor die Ladeprozedur begonnen wird.

6.  Verfahren nach Anspruch 5, **dadurch gekennzeichnet, daß** der Schritt des Ladens des ersten und des zweiten Kondensators (11, 12) auf mindestens etwa die gleiche Spannung mit Hilfe eines Vergleichers (COMP) ausgeführt wird,

    a) der die Spannungen (Uc1, Uc2) an jedem Kondensator (11, 12) miteinander vergleicht und
    b) der einen Schalter (S1) schließt, der innerhalb des/eines zweiten Teils (II) der Schaltung (CIRC) enthalten ist und der den zweiten Kondensator (12) entlädt, solange die Spannung (Uc2) an den zweiten Kondensator (12) über der Spannung (Uc1) an dem ersten Kondensator (11) liegt.

7.  Verfahren nach einem der vorhergehenden Ansprüche, **dadurch gekennzeichnet, daß** zu Vergleichszwecken Spannungsteiler (R1 und R2; R3 und R4) verwendet werden, um die Spannungen (Uc1, Uc2) zu reduzieren, auf die die Kondensatoren (11, 12) geladen werden.

8.  Vorrichtung für die Simulation des elektrischen Verhaltens eines piezoelektrischen Elements, insbesondere geeignet für die Verwendung mit dem Verfahren wie in einem der vorausgegangenen Ansprüche angeführt, wobei die Vorrichtung mindestens einen ersten Kondensator (11) und einen zweiten Kondensator (12) umfaßt, die in einem ersten Teil (I) einer Schaltung (CIRC) der Vorrichtung implementiert sind, wobei die Vorrichtung konfiguriert ist, den ersten Kondensator (11) und den zweiten Kondensator (12) durch den ersten Teil (I) der Schaltung (CIRC) gleichzeitig zu laden, **dadurch gekennzeichnet, daß** die Vorrichtung konfiguriert ist, nur den ersten Kondensator (11) durch den ersten Teil (I) der Schaltung (CIRC) zu entladen.

9.  Vorrichtung nach Anspruch 8, **dadurch gekennzeichnet, daß** der erste Kondensator (11) eine erste Kapazität (C1) aufweist und der zweite Kondensator (12) eine zweite Kapazität (C2) aufweist, wobei die erste Kapazität (C1) und die zweite Kapazität (C2) die Gleichung $\eta = C1/(C1 + C2)$ mindestens ungefähr erfüllen, wobei $\eta$ die Stromausbeute des simulierten piezoelektrischen Elements ist und C1 und C2 die Kapazitäten des ersten bzw. des zweiten Kondensators (11, 12) sind.

10. Vorrichtung nach Anspruch 8 oder 9, **dadurch gekennzeichnet, daß** sie einen zweiten Teil (II) einer Schaltung (CIRC) zum Entladen des zweiten Kondensators (12) umfaßt.

11. Vorrichtung nach Anspruch 10, **dadurch gekennzeichnet, daß** der zweite Teil (II) der Schaltung (CIRC) einen Entladecontroller zum Steuern einer Spannung (Uc2) an dem zweiten Kondensator (12) umfaßt.

12. Vorrichtung nach Anspruch 11, **dadurch gekennzeichnet, daß** der Entladecontroller die Spannung (Uc2) an dem zweiten Kondensator (12) in Abhängigkeit von einer Spannung (Uc1) an dem ersten Kondensator (11) steuert.

13. Vorrichtung nach Anspruch 12, **dadurch gekennzeichnet, daß** der Entladecontroller die Spannung (Uc2) an dem zweiten Kondensator (12) derart steuert, daß die Spannung (Uc2) an dem zweiten Kondensator (12) der Spannung (Uc1) an dem ersten Kondensator (11) folgt.

**14.** Vorrichtung nach Anspruch 11, 12 oder 13, **dadurch gekennzeichnet, daß** der Entladecontroller einen Schalter (S1) zum Steuern des Entladens des zweiten Kondensators (12) umfaßt.

**15.** Vorrichtung nach Anspruch 11, 12, 13 oder 14, **dadurch gekennzeichnet, daß** der Entladecontroller einen Widerstand (R5) zum Einstellen der Entladezeit des zweiten Kondensators (12) umfaßt.

**16.** Vorrichtung nach Anspruch 14 oder 15, **dadurch gekennzeichnet, daß** der Entladecontroller einen Vergleicher (COMP) zum Vergleichen der Spannungen (Uc1, Uc2) an dem ersten Kondensator (11) und dem zweiten Kondensator (12) und zum Schließen des Schalters (S1), solange die Spannung (Uc2) an dem zweiten Kondensator (12) über der Spannung (Uc1) an dem ersten Kondensator (11) liegt, umfaßt.

**17.** Vorrichtung nach einem der Ansprüche 8 bis 16, **dadurch gekennzeichnet, daß** der erste Teil (I) der Schaltung (CIRC) eine erste Diode (D1) umfaßt, eine Anode derer mit einem ersten Anschluß (N1) des ersten Kondensators (11) verbunden ist und eine Kathode derer mit einem ersten Anschluß des zweiten Kondensators (12) verbunden ist, daß der erste Teil (I) der Schaltung (CIRC) eine zweite Diode (D2) umfaßt, eine Anode derer mit dem zweiten Anschluß des zweiten Kondensators (12) verbunden ist und eine Kathode derer mit dem zweiten Anschluß (N2) des ersten Kondensators (11) verbunden ist, und **gekennzeichnet durch** eine dritte Diode (D3), eine Anode derer mit Massepotential verbunden ist und eine Kathode derer mit dem zweiten Anschluß des zweiten Kondensators (12) verbunden ist.

**18.** Vorrichtung nach Anspruch 17, **dadurch gekennzeichnet, daß** ein/der Schalter (S1) zum Steuern des Entladens des zweiten Kondensators (12) den ersten Anschluß des zweiten Kondensators (12) mit Massepotential verbindet, bevorzugt über einen Widerstand (R5).

**Revendications**

**1.** Procédé de simulation du comportement électrique d'éléments piézo-électriques, selon lequel

a) au moins un premier condensateur (11) et un second condensateur (12) sont chargés simultanément à travers une première partie (I) d'un circuit (CIRC) pendant une procédure de charge, **caractérisé en ce que**
b) au moins le premier condensateur (11) des au moins premier et second condensateurs (11, 12) est déchargé à travers la première partie (I) du circuit (CIRC) pendant une procédure de décharge, et au moins le second condensateur (12) des condensateurs (11, 12) n'est pas déchargé à travers la première partie (I) du circuit (CIRC) pendant cette procédure de décharge.

**2.** Procédé selon la revendication 1, **caractérisé en ce que** seul le premier condensateur (11) est déchargé à travers la première partie (I) du circuit (CIRC) pendant la procédure de décharge.

**3.** Procédé selon l'une des revendications précédentes, **caractérisé en ce que** le second condensateur (12) est déchargé à travers une seconde partie (II) du circuit (CIRC).

**4.** Procédé selon la revendication 3, **caractérisé en ce que** le second condensateur (12) est déchargé en commandant la tension (Uc2) sur le second condensateur (12) en fonction d'une tension (Uc1) sur le premier condensateur (11).

**5.** Procédé selon l'une des revendications précédentes, **caractérisé en ce que** le premier et le second condensateurs (11, 12) sont au moins approximativement à la même tension avant de démarrer la procédure de charge.

**6.** Procédé selon la revendication 5, **caractérisé en ce que** l'étape consistant à charger le premier et le second condensateurs (11, 12) sur au moins approximativement la même tension est effectuée au moyen d'un comparateur (COMP), qui

a) compare les tensions (Uc1, Uc2) sur chaque condensateur (11, 12) l'une par rapport à l'autre ; et
b) ferme un commutateur (S1), compris à l'intérieur de la ou d'une seconde partie (II) du circuit (CIRC) et qui décharge le second condensateur (12), dans la mesure où la tension (Uc2) sur le second condensateur (12) est supérieure à la tension (Uc1) sur le premier condensateur (11).

**7.** Procédé selon l'une des revendications précédentes, **caractérisé en ce que** des réducteurs de tension (R1 et R2 ; R3 et R4) sont utilisés, à des fins de comparaison, pour réduire les tensions (Uc1, Uc2) sur lesquelles les condensateurs (11, 12) sont chargés.

**8.** Dispositif de simulation du comportement électrique d'un élément piézo-électrique, en particulier éligible pour être utilisé avec le procédé selon l'une des revendications précédentes,
dans lequel
le dispositif comprend au moins un premier condensateur (11) et un second condensateur (12) qui sont mis en oeuvre dans une première partie (I) d'un circuit (CIRC) du dispositif, le dispositif étant configuré pour charger simultanément le premier condensateur (11) et le second condensateur (12) à travers la première partie (I) du circuit (CIRC),
**caractérisé en ce que**
le dispositif est configuré pour décharger seulement le premier condensateur (11) à travers la première partie (I) du circuit (CIRC).

**9.** Dispositif selon la revendication 8,
**caractérisé en ce que**
le premier condensateur (11) a une première capacité (C1) et le second condensateur (12) a une seconde capacité (C2), et la première capacité (C1) et la seconde capacité (C2) satisfont au moins approximativement l'équation $\eta = C1 / (C1 + C2)$, où $\eta$ représente le rendement électrique de l'élément piézo-électrique simulé et C1 et C2 sont les capacités du premier, respectivement du second, condensateur (11, 12).

**10.** Dispositif selon la revendication 8 ou 9,
**caractérisé en ce qu'**
il comprend une seconde partie (II) d'un circuit (CIRC) pour décharger le second condensateur (12).

**11.** Dispositif selon la revendication 10,
**caractérisé en ce que**
la seconde partie (II) du circuit (CIRC) comprend un régulateur de décharge pour commander une tension (Uc2) sur le second condensateur (12).

**12.** Dispositif selon la revendication 11,
**caractérisé en ce que**
le régulateur de décharge commande la tension (Uc2) sur le second condensateur (12) en fonction d'une tension (Uc1) sur le premier condensateur (11).

**13.** Dispositif selon la revendication 12,
**caractérisé en ce que**
le régulateur de décharge commande la tension (Uc2) sur le second condensateur (12) de telle sorte que la tension (Uc2) sur le second condensateur (12) suive la tension (Uc1) sur le premier condensateur (11).

**14.** Dispositif selon la revendication 11, 12 ou 13,
**caractérisé en ce que**
le régulateur de décharge comprend un commutateur (S1) pour commander la décharge du second condensateur (12).

**15.** Dispositif selon la revendication 11, 12, 13 ou 14,
**caractérisé en ce que**
le régulateur de décharge comprend une résistance (R5) pour ajuster le temps de décharge du second condensateur (12).

**16.** Dispositif selon la revendication 14 ou 15,
**caractérisé en ce que**
le régulateur de décharge comprend un comparateur (COMP) pour comparer les tensions (Uc1, Uc2) sur le premier condensateur (11) et le second condensateur (12), et pour fermer le commutateur (S1) dans la mesure où la tension (Uc2) sur le second condensateur (12) est supérieure à la tension (Uc1) sur le premier condensateur (11).

**17.** Dispositif selon l'une des revendications 8 à 16,
**caractérisé en ce que**
la première partie (I) du circuit (CIRC) comprend une première diode (D1), dont une anode est reliée à une première borne (N1) du premier condensateur (11) et dont une cathode est reliée à une première borne du second condensateur (12),
la première partie (I) du circuit (CIRC) comprend une seconde diode (D2), dont une anode est reliée à la seconde borne du second condensateur (12) et dont une cathode est reliée à la seconde borne (N2) du premier condensateur (11), et
une troisième diode (D3), a une anode reliée au potentiel de masse et une cathode reliée à la seconde borne du second condensateur (12).

**18.** Dispositif selon la revendication 17,
**caractérisé en ce qu'**
un/le commutateur (S1) destiné à commander la décharge du second condensateur (12) relie la première borne du second condensateur (12) au potentiel de masse, de préférence via une résistance (R5).

FIG. 1

CIRC

B1

B2

R1

R2

D1

D2

D3

N1

N2

11

12

I

II

R3

R4

R5

S1

COMP

+

−

FIG. 2

CIRC

R5
S1
COMP
+ −

II

R3
R4

I

$i_{c2}$
12
D3

D1
11
N2
D2

$i_{c1}$
N1

$i_c$
B1
R1
$i_c$
B2
R2

# FIG. 3

EP 1 186 897 B1

FIG. 4